# EUROPÄISCHE PATENTSCHRIFT

(11) **EP 2 246 984 B1**
(45) Veröffentlichungstag und Bekanntmachung des Hinweises auf die Patenterteilung: **03.07.2013**
(21) Anmeldenummer: 09158909.3
(22) Anmeldetag: 28.04.2009
(51) Int. Cl.: H03M 1/10

(54) **Diagnoseschaltung zur Überwachung einer Analog-Digital-Wandlungsschaltung**
Diagnosis apparatus for monitoring an analogue-digital conversion apparatus
Appareil de diagnostic destinée au contrôle d'un appareil de conversion analogique-numérique

(43) Veröffentlichungstag der Anmeldung: 03.11.2010
(73) Patentinhaber: VEGA Grieshaber KG, 77709 Wolfach (DE)
(72) Erfinder: Schaetzle, Ralf, 77716 Fischerbach (DE); Kopp, Manfred, 77709 Wolfach (DE)
(74) Vertreter: Maiwald Patentanwalts GmbH

(56) Entgegenhaltungen:
- EP-A1- 1 517 200
- EP-A1- 1 968 195
- US-A1- 2007 252 744
- US-B1- 6 434 504

## Beschreibung

### GEBIET DER ERFINDUNG:

Die Erfindung betrifft die Analog-Digital-Wandlung von Sensorwerten.
Insbesondere betrifft die Erfindung eine Diagnoseschaltung zur Überwachung einer Analog-Digital-Wandlungsschaltung beim Einlesen eines Messwertes eines Füllstands-, Druck- oder Durchflussmessgeräts, ein Füllstandsmessgerät mit einer Diagnoseschaltung, ein Druckmessgerät mit einer Diagnoseschaltung, ein Durchflussmessgerät mit einer Diagnoseschaltung sowie ein Verfahren zur Überwachung einer Analog-Digital-Wandlungsschaltung.

### TECHNISCHER HINTERGRUND:

Der grundsätzliche Aufbau eines Eingangs für Analogsensoren besteht aus einem in einer Messschleife integrierten Widerstand, über welchem ein Spannungsabfall gemessen werden kann. Ist der Widerstandswert theoretisch bekannt, so kann der Strom anhand der gemessenen Spannung berechnet werden. Es sind keine Überwachungsmaßnahmen vorgesehen, das heißt es wird nicht erkannt, ob der berechnete Strom auch dem tatsächlichen Sensorstrom entspricht.

Mit einem solchen Aufbau können Veränderungen, die beispielsweise temperaturbedingt sind, nicht entgegengewirkt werden.

Gerade im Bereich der Füllstands- und Druckmessung ist ein genaues Bestimmen von Sensorwerten, mit anderen Worten ein genaues Bestimmen von Füllständen und Drücken, von erheblicher Bedeutung. Fehlmessungen können nicht nur technische Folgen wie eine Überstrapazierung von Rohrmaterial im Falle eines zu hohen Druckes mit erheblichen sicherheitstechnischen Konsequenzen mit sich bringen. Oft sind damit zusätzliche wirtschaftliche Folgen mit Nachteilen für den Verwender eines Sensors, also eines Füllstands- und Druckmessgeräts, verbunden.

Die US 2007/0252744 A1 zeigt eineSchaltung mit einem Analog-Digital-Wandler, bei welcher Schaltung über die Ausgabe eines Verstärkers die Funktionstüchtigkeit von Schlatern innerhalb der Schaltung festgestellt wird.

Die EP 1 517 200 A1 zeigt eine Steuereinheit, welche eine erste und eine zweite Prozesseinheit aufweist und welche neben einem normalen Programm auch eine Sicherheitsprogramm ausführen kann.

Die US 6,434,504 B1 zeigt eine Steuereinheit, welche Messungen des Selbsterwärmungsindex von Widerständen zur Steuereung verwendet.

Die EP 1 968 195 zeigt einen Analog-Digital-Wandler, der eine Fehlerkorrektur für seinen digitalen Ausgang durchführt. Dabei können mehere Referenzspannungen zum einsatz kommen.

### ZUSAMMENFASSUNG DER ERFINDUNG:

Es ist eine Aufgabe der Erfindung, eine verbesserte Analog-Digital-Wandlung beim Einlesen eines Messwertes eines Füllstands-, Druck- oder Durchflussmessgeräts anzugeben.

Es sind eine Diagnoseschaltung zur Überwachung einer Analog-Digital-Wandlungsschaltung beim Einlesen eines Messwertes eines Füllstands-, Druck- oder Durchflussmessgeräts, ein Füllstandsmessgerät, ein Druckmessgerät, ein Durchflussmessgerät und ein Verfahren zur Überwachung einer Analog-Digital-Wandlungsschaltung beim Einlesen eines Messwertes eines Füllstands-, Druck- oder Durchflussmessgeräts gemäß den Merkmalen der unabhängigen Ansprüche angegeben. Weiterbildungen der Erfindung ergeben sich aus den Unteransprüchen.

Die beschriebenen Ausführungsbeispiele betreffen gleichermaßen die Diagnoseschaltung, das Füllstandsmessgerät, das Druckmessgerät, das Durchflussmessgerät und das Verfahren.

Es sei weiterhin darauf hingewiesen, dass im Kontext der Erfindung der Begriff Sensor den Begriff Messgerät insbesondere die Begriffe Füllstandsmessgerät, Druckmessgerät und Durchflussmessgerät umfasst. Weiterhin ist der Begriff Sensorwert dahingehend zu verstehen, dass ein analoges Signal des Sensors, welches durch die Erfindung in ein digitales Signal gewandelt wird, der Diagnoseschaltung zugeführt wird. Dabei kann es sich beispielsweise um einen elektrischen Sensorstrom handeln, der durch die Erfindung in ein analoges Signal gewandelt wird.

Der Begriff Stromfühlwiderstandseinheit kann dabei elektrische Widerstände, Induktivitäten und Kapazitäten umfassen.

Weiterhin sei angemerkt, dass der Begriff elektrischer Widerstand im Kontext der Erfindung stets unter den Begriff Stromfühlwiderstandseinheit fallend zu lesen ist.

Gemäß einem Ausführungsbeispiel der Erfindung ist eine Diagnoseschaltung zur Überwachung einer Analog-Digital-Wandlungsschaltung beim Einlesen eines Messwertes eines Füllstands-, Druck- oder Durchflussmessgeräts angegeben. Dabei weist die Diagnoseschaltung einen Multiplexer zum Auswählen verschiedener Signale und einen ersten Mikrokontroller zum Steuern zumindest des Multiplexers auf. Weiterhin wird dem Mikrokontroller eine Versorgungsspannung bereitgestellt und die Diagnoseschaltung ist zur Detektion einer Änderung der Versorgungsspannung auf Basis eines Vergleichs der Versorgungsspannung mit einem gespeicherten Versorgungsspannungs-Referenzwertes der Versorgungsspannung unter Verwendung des Multiplexers und des ersten Mikrokontrollers ausgeführt.

Dabei kann der Messwert der Diagnoseschaltung beispielsweise durch einen elektrischen Strom bereitgestellt werden. Dieser kann nach einer Spannungsmessung an einer ersten Strohmfühlwiderstandseinheit, die als elektrischer Widerstand ausgeführt sein kann bei bekanntem Wert der Strohmfühlwiderstandseinheit berechnet werden. Dies kann falls gewünscht auch von der Diagnoseschaltung umfasst und bereitgestellt werden.

Dabei kann die Diagnoseschaltung Teil eines Sensors, also eines Druckmessgeräts, Füllstandsmessgerät oder Durchflussmessgeräts sein. Aber auch eine von dem Sensor beabstandete Anbringung dieser Diagnoseschaltung ist möglich. In diesem Fall wird der vom Sensor ermittelte Messwert der Diagnoseschaltung beispielsweise über eine elektrische Leitung mittels eines elektrischen Stroms zugeführt. Aber auch andere Zuführungen der Messwerte sind möglich.

Im speziellen Fall, dass der Sensor ein Füllstands-, Druck- oder Durchflussmessgerät ist, handelt es sich bei dem Messwert somit um einen Füllstand, Druck, oder um einen Durchfluss. Dieser kann beispielsweise durch den Sensor mittels elektromagnetischer Wellen ermittelt worden sein.

Weiterhin kann die Stromfüllwiderstandseinheit einen oder mehrere elektrische Widerstände umfassen, die derart in der Diagnoseschaltung geschaltet sind, dass ein jeweiliges Auslesen der Spannung, die an den jeweiligen elektrischen Widerständen beim Betrieb der Diagnoseschaltung abfällt, erfolgen kann. Auch können die Spannungen gemessen werden, die insgesamt an mehreren hintereinander geschalteten elektrischen Widerständen abfällt.

Weiterhin kann der Analog-Digital-Wandler nach unterschiedlichsten Methoden analoge Eingangssignale in digitale Daten bzw. einen Datenstrom umsetzen. Diese können dann weiterverarbeitet oder gespeichert werden. Eine anschließende Weiterverarbeitung durch das Gegenstück, den Digital-Analog-Wandler, ist möglich. Zur prinzipiellen Funktionsweise eines Analog-Digital-Wandlers sei angemerkt, dass der Analog-Digital-Wandler ein kontinuierliches Spannungssignal sowohl in der Zeit als auch in der Amplitude quantisiert. Dabei können dem Analog-Digital-Wandler mehrere Auflösungen in Bit und mehrere Umsetzgeschwindigkeiten vorgegeben werden.

Weiterhin kann der Multiplexer als Selektionsschaltnetz ausgeführt sein, mit dem aus einer Anzahl von Eingangssignalen an den Eingangskanälen des Multiplexers eines ausgewählt werden kann. diese Eingangssignale können z.B. die Versorgungspannung, Spannungen die an einzelnen oder hintereinandergeschalteten Widerständen abfällt oder Spannungen die durch ein Potentiometer oder in sonstiger Weise vorgegeben werden sein.

Es können somit mit einem zyklischen Durchlauf der Eingangskanäle des Multiplexers parallele Datenströme in serielle gewandelt werden. Beispielsweise können mittels eines Durchschaltens des Multiplexers verschiedene Spannungszustände an verschiedenen Eingängen des Multiplexers durch den Multiplexer gemessen werden. Somit hat der Multiplexer eine Mehrzahl von Eingängen oder Eingangskanälen und zumindest einen Ausgang, wobei je nach Schaltungszustand des Multiplexers jeweils dasjenige Eingangssignal am Ausgang anliegt dessen Kanal vom Multiplexer gerade angesteuert wird.

Das Ausgangssignal des Multiplexers kann dann an den Analog-Digital-Wandler weitergegeben werden. Dabei sind die vom Multiplexer auszuwählenden verschiedenen Signale diejenigen analogen Signale, also zum Beispiel ein Sensorstrom, eine Spannung, die über eine Stromfühlwiderstandseinheit abfällt, eine Spannung, die über mehrere Stromfühlwiderstandseinheiten abfällt, eine Spannung, die durch ein Potentiometer vorgegeben wird, eine Versorgungsspannung des Mikrocontrollers oder jedes andere analoge Signal, das von dem Sensor bei der Messung des Messwertes erzeugt wird.

Weiterhin ist der erste Mikrocontroller beispielsweise als Halbleiterchip ausgeführt. Dabei ist der Mikrocontroller praktisch ein 1-Chip-Computersystem. Es kann daher auch der Begriff "System on a Chip" für einen Mikrocontroller, der im Kontext der Erfindung verwendet wird, benutzt werden. Weiterhin kann der Mikrocontroller über programmierbare digitale und/oder analoge Funktionsblöcke verfügen.

Weiterhin können sich auf dem Mikrocontroller sogenannte Peripheriefunktionen wie zum Beispiel Controller Area Network Funktionen, Local Interconnect Network Funktionen, Universal Serial Bus Funktionen, Inter-Integrated Circuit Funktionen, Serial Peripheral Interface Funktionen, serielle oder Ethernet-Schnittstellen, PWM-Ausgänge, LCD-Controller und Treiber, Analog-Digital-Wandler und Multiplexer befinden.

Weiterhin kann der erste Mikrocontroller ausgeführt sein, jegliche Referenzwerte, die im Kontext der Erfindung beschrieben sind, zu speichern. Ebenso ist es möglich, Ablaufdiagramme oder Protokolle verschiedener Vorgänge auf dem Mikrocontroller zu speichern. Auf zwei spezielle zyklische Abläufe bzw. Ablaufdiagramme wird im Folgenden noch näher eingegangen. Dabei sind diese beiden zyklischen Abläufe ein wichtiger Aspekt der Erfindung. Weiterhin kann der Mikrocontroller ausgeführt sein, um den Multiplexer und den Analog-Digital-Wandler zu steuern und zu regeln.

Weiterhin ist es möglich, dass der Mikrocontroller auf einer Platine ausgeführt ist und die Merkmale der Diagnoseschaltung Analog-Digital-Wandler und Multiplexer enthält. Es ist somit eine integrale Ausgestaltung dieser Bauteile angegeben. Aber auch eine diskrete Anordnung des Multiplexers und eine diskrete Anordnung des Analog-Digital-Wandlers mit einem separaten ersten Mikrocontroller innerhalb der Diagnoseschaltung ist möglich.

Weiterhin kann der gespeicherte Versorgungsspannungs-Referenzwert und / oder andere Referenzwerte im ersten Mikrocontroller gespeichert sein. Aber auch eine Speicherung auf einem zweiten Mikrocontroller in einem zweiten Bereich, auf einem externen separaten Speicher, auf einem Speicher auf der Platine, auf der der erste Mikrocontroller, der Analog-Digital-Wandler und der Multiplexer angeordnet sind, ist möglich. Aber auch eine Speicherung des Versorgungsspannungs-Referenzwertes auf einem dritten Mikrocontroller ist möglich. Mit anderen worten muss die Speicherung von Referenzwerten nicht im Mikrocontroller erfolgen. Die Werte können auch in einem externen Speicher, auf den der entsprechende Mikrocontroller Zugriff hat, abgespeichert werden. Dabei kann dieser weitere Mikrocontroller beabstandet von dem ersten Mikrocontroller sein und in einem anderen Bereich der Diagnoseschaltung liegen, der andere Sicherheitskriterein und /oder Normen erfüllt, als der Bereich des ersten Mikrocontrollers. Weiterhin können beide Mikrocontroller unterschiedliche Sicherheitserfordernisse erfüllen und können durch einen beispielsweise unidirektionalen optischen Koppler (Optokoppler) miteinander verbunden sein. Dabei kann der Optokoppler derart ausgeführt sein, dass er einen Sicherheitsabstand, der zwischen dem ersten und dem zweiten Mikrocontroller angeordnet ist, überbrückt.

Im Folgenden wird der Vorgang der Detektion durch die Diagnoseschaltung einer Änderung der Versorgungsspannung gemäß diesem Ausführungsbeispiel der Erfindung detaillierter beschrieben:
Es kann beispielsweise einmalig bei einem Kalibrieren der Diagnoseschaltung der Versorgungsspannungs-Referenzwert an dem gewünschten Ort gespeichert werden. Mittels des Multiplexers kann die Versorgungsspannung, die dem Mikrocontroller bereitgestellt wird, abgegriffen und gemessen werden. Weiterhin wird sie durch den Multiplexer an den Analog-Digital-Wandler weitergegeben. Der Analog-Digital-Wandler wandelt somit das analoge Signal der Versorgungsspannung in ein digitales Signal um. Dies kann als digitales Versorgungsspannungssignal bezeichnet werden.
Stimmt nun dieses digitale Versorgungsspannungssignal nicht mit dem zuvor gespeicherten Versorgungsspannungs-Referenzwert überein, so kann von der Diagnoseschaltung festgestellt werden, dass entweder der Analog-Digital-Wandler eine Fehlfunktion aufweist oder eine Referenzdiode des Analog-Digital-Wandlers defekt ist.

Die Referenzdiode kann im AD-Wandler integriert sein oder auch extern angebracht sein. Die Referenzdiode dient dem AD-Wandler als Referenzwert, d.h. ändert sich der Referenzwert werden auch die AD-Wandler Werte entsprechend verfälscht. Eine Referenzdiode kann z.B. eine hochgenaue Zenerdiode sein, deren Spannungswert nur innerhalb der eng spezifizierten Grenzen driftet bzw. über die Temperatur wegläuft.

Deshalb ist es mit dieser Diagnoseschaltung möglich, Fehler in der Analog-Digital-Wandlerschaltung aufzudecken. Es kann somit beispielsweise ein Wegdriften der Referenzspannung des Analog-Digital-Wandlers detektiert werden. Dabei können alle Kalibrierwerte des Analog-Digital-Wandlers in der oben angegebenen Art an dem gewünschten Ort gespeichert sind.

Gemäß einem weiteren Ausführungsbeispiel der Erfindung weist die Diagnoseschaltung eine erste und zweite Stromfühlwiderstandseinheit auf. Dabei ist die Diagnoseschaltung zur Detektion einer Änderung einer der beiden Stromfühlwiderstandseinheiten auf Basis eines Vergleichs mit einem gespeicherten Widerstands-Referenzwert der Stromfühlwiderstandseinheiten ausgeführt.

Dabei können auch mehrere Widerstands-Referenzwerte gespeichert sein. Ebenso wie der Versorgungsspannungs-Referenzwert können die Widerstands-Referenzwerte in dem ersten Mikrocontroller gespeichert sein, auf einem externen separaten Speicher gespeichert sein oder auch auf einem zweiten weiteren Mikrocontroller gespeichert sein. Dabei kann beispielsweise das Verhältnis aus der Summe der ersten und zweiten Stromfühlwiderstandseinheit zu der zweiten Stromfühlwiderstandseinheit gespeichert sein oder auch das Verhältnis aus der ersten Stromfühlwiderstandseinheit und der zweiten Stromfühlwiderstandseinheit.

Dabei können die erste Stromfühlwiderstandseinheit und die zweite Stromfühlwiderstandseinheit als elektrische Widerstände ausgeführt sein. In diesem Fall kann der Widerstands-Referenzwert beispielsweise dem Verhältnis aus der Summe des ersten und zweiten elektrischen Widerstandes zu dem zweiten elektrischen Widerstandes oder ersten elektrischen Widerstandes entsprechen. Ebenso ist es möglich, dass beide elektrischen Widerstände einzeln als zwei Widerstands-Referenzwerte gespeichert sind.

Im Folgenden wird im Detail die Detektion einer Änderung einer der beiden Stromfühlwiderstandseinheiten beschrieben: Beispielsweise können dem Multiplexer der Spannungsabfall über den beiden Stromfühlwiderstandseinheiten und der Spannungsabfall über einer der beiden Stromfühlwiderstandseinheiten zur Verfügung gestellt werden. Aus einem Vergleich des Verhältnisses dieser beiden Spannungsabfälle mit dem gespeicherten Wert, also dem Widerstands-Referenzwert, kann ein Wegdriften einer der beiden Stromfühlwiderstandseinheiten erkannt werden. Mit anderen Worten kann aus dem Spannungsverhältnis bestehend aus einer ersten Spannung, die an beiden elektrischen Widerständen abfällt, und einer zweiten Spannung, die an einem der beiden elektrischen Widerstände abfällt, das momentane Verhältnis der beiden Widerstände bestimmt werden. Dieses Verhältnis wird mit dem Widerstands-Referenzwert, der gespeichert ist, verglichen. Ein Vergleich dieser beiden Widerstandsverhältnisse ist somit in der Lage, eine Veränderung zumindest einer der beiden Widerstände aufzudecken. Dabei kann eine Veränderung beispielsweise durch thermische Veränderung oder durch Altersprozesse durch die Diagnoseschaltung detektiert werden.

Gemäß einem weiteren Ausführungsbeispiel der Erfindung ist die Diagnoseschaltung zur Detektion einer Änderung einer der beiden Strohmfühlwiderstandseinheiten auf Basis eines Vergleichs des Widerstandsverhältnisses der beiden Stromfühlwiderstandseinheiten ausgeführt ist.

Gemäß einem weiteren Ausführungsbeispiel der Erfindung ist die Diagnoseschaltung im Falle einer Detektion einer Änderung einer der beiden Stromfühlwiderstandseinheiten zur Durchführung einer entsprechenden Anpassung des gespeicherten Widerstands-Referenzwertes der Stromfühlwiderstandseinheiten ausgeführt.

Somit ist die Diagnoseschaltung in der Lage, einen neuen Referenzwert an denjenigen Speicherort neu einzutragen, an dem der Referenzwert bisher gespeichert wurde. Diese Durchführung kann durch die Diagnoseschaltung für jeden Referenzwert, der innerhalb der Erfindung verwendet wird, durchgeführt werden.

Gemäß einem weiteren Ausführungsbeispiel der Erfindung weist die Diagnoseschaltung weiterhin einen Analog-Digital-Wandler zum Wandeln eines analogen Signals in ein digitales Signal und ein Potentiometer zur Erzeugung eines analogen Potentiometersignals auf. Dabei wandelt der Analog-Digital-Wandler das Potentiometersignal in ein digitales Potentiometersignal um. Weiterhin ist die Diagnoseschaltung zur Detektion einer Fehlfunktion des Analog-Digital-Wandlers auf Basis eines Vergleichs des analogen Potentiometersignals mit dem digitalen Potentiometersignal ausgeführt.

Dabei kann es sich bei dem Potentiometer um ein digitales Potentiometer handeln. Mit anderen Worten kann mittels des Digitalpotentiometers der gesamte Arbeitsbereich des Analog-Digital-Wandlers hinsichtlich eines Spannungsbereiches überprüft werden. Dem Analog-Digital-Wandler können mittels des Digitalpotentiometers alle Spannungswerte vorgegeben werden, die er laut seiner Betriebsfunktion ordnungsgemäß in digitale Signale umwandeln können soll. Dabei wird das von dem Potentiometer zur Verfügung gestellte analoge Potentiometersignal durch den Multiplexer ausgewählt und dem Analog-Digital-Wandler zugeführt. Dabei kann beispielsweise in einem zweiten Mikrocontroller ein zyklischer Ablauf gespeichert sein, in dem zeitlich festgelegt wird, welches analoge Potentiometersignal durch das Potentiometer auf den Analog-Digital-Wandler gegeben wird. Das auf Basis dieses eingegebenen Signals gewandelte digitale Ausgangssignal (digitales Potentiometersignal) des Wandlers kann dann gemessen werden und beispielsweise an den zweiten Mikrocontroller übertragen werden. Dieser zweite Mikrocontroller vergleicht diesen Wert mit demjenigen gespeicherten Wert, der laut dem gespeicherten zyklischen Ablauf nun eigentlich vom Wandler ausgegeben werden müsste (Sollwert des digitalen Potentiometersignals, das als Referenzwert dient).

Mit anderen Worten erwartet der zweite Mikrocontroller aufgrund des in ihm gespeicherten zyklischen Ablaufes der Überprüfung des Analog-Digital-Wandlers die digitalen Potentiometersignals, die das Potentiometer ausgibt und die durch den Analog-Digital-Wandler gewandelt werden. Stimmen die Werte nicht überein, deutet dies auf einen fehlerhaften Analog-Digital-Wandler oder eine fehlerhafte Referenzdiode hin. Dies kann die Diagnoseschaltung detektieren.

Gemäß einem weiteren Ausführungsbeispiel der Erfindung weist die Diagnoseschaltung einen zweiten Mikrocontroller auf. Weiterhin ist der zweite Mikrocontroller zur Detektion einer fehlerhaften Programmausführung des ersten Mikrocontrollers ausgeführt.

Mittels des zweiten Mikrocontrollers kann beispielsweise eine Programmausführung, die auf dem ersten Mikrocontroller gespeichert ist, kontrolliert werden. Kann der erste Mikrocontroller beispielsweise ein ersten Programm enthalten, das den ersten Mikrocontroller veranlasst, zyklisch die folgenden Werte des Analog-Digital-Wandlers an den zweiten Mikrocontroller zu übertragen: 1. Versorgungsspannung des ersten Mikrocontrollers, 2. Spannungsabfall über die erste und die zweite Stromfühlwiderstandseinheit, 3. Spannungsabfall über eine der beiden Stromfühlwiderstandseinheiten und das digitale Potentiometersignal, das auf dem analogen Signal des Potentiometers basiert und gewandelt wird. Diese vier Punkte entsprechen einem ersten zyklischen Ablauf. Stimmt die zeitliche Abfolge dieser Werte, die vom ersten Mikrocontroller durch Schaltung des Multiplexers mit anschließender Übergabe des Wertes von dem Multiplexer an den Analog-Digital-Wandler und anschließender Übertragung an den zweiten Mikrocontroller nicht mit den vom zweiten Mikrocontroller erwarteten zeitlichen Abfolge überein, so kann von der Diagnoseschaltung somit ein Programmausführungsfehler im ersten Mikrocontroller detektiert werden. Aber auch die Detektion eines Übertragungsfehlers zwischen dem ersten Mikrocontroller und dem zweiten Mikrocontroller durch die Diagnoseschaltung ist damit gegeben.

Mit anderen Worten steuert und regelt der erste Mikrocontroller sowohl den Multiplexer als auch die Übertragung der Signale an den Analog-Digital-Wandler und eine weitere Übertragung von dem Analog-Digital-Wandler an den zweiten Mikrocontroller gemäß einem ersten zyklischen Ablauf mittels eines Programms, das auf dem ersten Mikrocontroller gespeichert ist. Im zweiten Mikrocontroller sind entsprechende Referenzwerte gespeichert, weshalb der zweite Mikrocontroller eine gewisse zeitliche Abfolge der Referenzwerte erwartet. Bei einer Abweichung der übertragenen Werte von dem gespeicherten zeitlichen Ablauf kann eine oben angegebene Detektion durch die Diagnoseschaltung stattfinden.

Gemäß einem weiteren Ausführungsbeispiel der Erfindung weist die Diagnoseschaltung einen unidirektionalen Koppler auf, wobei die erste Stromfühlwiderstandseinheit, der Analog-Digital-Wandler, der Multiplexer und der erste Mikrocontroller in einem ersten Bereich der Schaltung angeordnet sind. Weiterhin ist der zweite Mikrocontroller in einem zweiten Bereich der Schaltung angeordnet, wobei der zweite Bereich höhere Sicherheitsanforderungen als der erste Bereich erfüllt. Weiterhin ermöglicht der Koppler eine unidirektionale Signalübertragung von dem ersten Bereich in den zweiten Bereich und weiterhin ist der oder die Referenzwerte im zweiten Bereich gespeichert.

Somit weist die Diagnoseschaltung einen ersten und einen zweiten Bereich auf. Dabei kann der erste Bereich beispielsweise als Sensoreingang und der zweite Bereich beispielsweise als Digitalteil bezeichnet werden. Weiterhin ist ein dritter Teil, in dem sich das Netzteil befindet, möglich. Beispielsweise kann der erste Bereich Sensoreingang die Sicherheitsanforderungen eines "eigensicheren Stromkreises" erfüllen. Bei dem Gerät handelt es sich dann um ein sogenanntes "zugehöriges elektrisches Betriebsmittel", dabei handelt es sich um ein elektrisches Betriebsmittel, das sowohl eigensichere als auch nicht eigensichere Stromkreise enthält und so aufgebaut ist, daß die nicht eigensichere Stromkreise die eigensichere Stromkreise nicht beeinträchtigen können. Ein eigensicherer Stromkreis ist ein Stromkreis, in dem kein Funke oder kein thermischer Effekt zu einer Zündung einer explosionsfähigen Atmosphäre führen kann (Der Explosionsschutz ist in der ATEX-Produktrichtlinie 94/9/EG beschrieben).

Beispielsweise können diese beiden Bereiche durch eine Minimumentfernung getrennt auf einer Platine angeordnet sein. Dieser Minimumabstand kann beispielsweise durch den unidirektionalen Koppler überbrückt werden. Dabei kann der unidirektionale Koppler beispielsweise als unidirektionaler Optokoppler ausgeführt sein. Durch die unidirektionale Kopplung, also eine Kopplung, die lediglich eine Übertragung elektromagnetischer Signale in eine Richtung erlaubt, ist eine elektrische Entkopplung der beiden Bereiche durch den unidirektionalen Koppler gegeben. Da der zweite Bereich, der Digitalteil mit dem zweiten Mikrocontroller höhere Sicherheitsanforderungen erfüllen muss, ist der zweite Mikrocontroller besser durch störende äußere Einflüsse wie beispielsweise Hitze, Explosionen, mechanische Einwirkungen, magnetische Einwirkungen und elektromagnetische Einwirkungen geschützt. Dieser Sicherheitsvorteil des zweiten Bereichs wird ausgenutzt, um die wertvollen Referenz- und Prüfwerte, die im Kontext der Erfindung verwendet werden, dort zu speichern. Mittels dieser Referenz- und Prüfwerte können die Funktionen des ersten Mikrocontrollers bzw. die Funktion des Analog-Digital-Wandlers im ersten Bereich sowie die Werte der Stromfühlwiderstandseinheiten gesichert überprüft werden. Auch nach dem Auftreten störender Einflüsse, wie beispielsweise eines Brandes, kann davon ausgegangen werden, dass die Überprüfung und Überwachung der Analog-Digital-Wandlungsschaltung korrekt funktioniert, da die Referenz- und Prüfwerte nicht durch diese Einflüsse beeinträchtigt worden sein können.

Gemäß einem weiteren Ausführungsbeispiel der Erfindung weist die Diagnoseschaltung einen bidirektionalen Koppler auf, wobei die erste Stromfühlwiderstandseinheit, der Analog-Digital-Wandler, der Multiplexer in einem ersten Bereich der Schaltung angeordnet sind. Dabei ist der erste Mikrocontroller in einem zweiten Bereich der Schaltung angeordnet, wobei der zweite Bereich höhere Sicherheitsanforderungen als der erste Bereich erfüllt. Weiterhin ist der Koppler dazu ausgeführt, eine bidirektionale Signalübertragung von dem ersten Bereich in den zweiten Bereich zu ermöglichen. Der erste Mikrocontroller ist weiterhin zum Regeln zumindest von dem Multiplexer oder dem Analog-Digital-Wandler ausgeführt.

Mit anderen Worten ist der erste Mikrocontroller in den Bereich mit höheren Sicherheitsanforderungen platziert. Weiterhin sind die Referenz- und Prüfwerte, die im Kontext der Erfindung zur Überwachung der Analog-Digital-Wandlungsschaltung verwendet werden, in dem ersten Mikrocontroller gespeichert. Aufgrund des bidirektionalen Kopplers kann nun von außen, also von dem gesicherten zweiten Bereich, auf den Multiplexer und den Analog-Digital-Wandler zugegriffen werden. Somit ist diese Diagnoseschaltung in der Lage, das Wegdriften der Stromfühlwiderstandseinheiten und das Wegdriften der Referenzspannung des Analog-Digital-Wandlers in oben angegebener Weise zu detektieren. Ebenso kann beispielsweise durch den ersten Mikrocontroller ein Potentiometer, das sich im ersten Bereich befindet, geregelt und gesteuert werden. Somit kann auch mit dem oben angegebenen Detektionsprozess mittels eines Potentiometers ein fehlerhafter Analog-Digital-Wandler erkannt werden. Dabei kann weiterhin beispielsweise zyklisch von dem ersten Mikrocontroller der Multiplexer derart angesteuert werden, dass in folgender Reihenfolge die folgenden Werte übertragen werden. Versorgungsspannung des ersten Mikrocontrollers, Spannungsabfall über beide Stromfühlwiderstandseinheiten, Spannungsabfall über eine der beiden Stromfühlwiderstandseinheiten und der Referenzwert bzw. der Prüfwert, der mittels des Potentiometers vorgegeben wird. Die anschließend in dieser Reihenfolge an den ersten Mikrocontroller über den bidirektionalen Koppler angegebenen Werte können dann mit den Referenz- und Prüfwerten, die innerhalb des ersten Mikrocontrollers gespeichert sind, überprüft werden.

Gemäß einem weiteren Ausführungsbeispiel der Erfindung weist der erste Bereich Anforderungen eines eigensicheren Stromkreises auf und der zweite Bereich ist als nichteigensicherer Stromkreis ausgeführt.

Dabei ist der erste Bereich entsprechend vom zweiten Bereich getrennt. Das Gesamtgerät erfüllt aber eine Sicherheitsnorm.

Dabei kann die Sicherheitsnorm beispielsweise die SIL3 oder die SIL4 Norm sein. Aufgrund der Trennung in diese beiden Bereiche kann eine sichere Überwachung einer Analog-Digital-Wandlung durch die Diagnoseschaltung bereitgestellt werden.

Gemäß einem weiteren Ausführungsbeispiel der Erfindung weist die Diagnoseschaltung eine galvanische Trennung zwischen dem ersten und dem zweiten Bereich auf.

Durch diese elektrische Entkopplung kann sichergestellt werden, dass keine elektrischen Signale und Störeinflüsse zwischen den beiden Bereichen ausgetauscht werden.

Gemäß einem weiteren Ausführungsbeispiel der Erfindung ist zumindest ein Element ausgewählt aus der Gruppe bestehend aus erster Mikrocontroller, Multiplexer, Analog-Digital-Wandler, Potentiometer, erste Stromfühlwiderstandseinheit, und zweite Stromfühlwiderstandseinheit als diskretes, separates Bauteil ausgeführt.

Im Gegensatz zu einer Variante, bei der auf einer Platine als integriertes System ein Mikrocontroller, einen Multiplexer und einen Analog-Digital-Wandler enthalten kann, kann auch ein diskreter Aufbau realisiert werden, der die Funktionen der oben angegebenen Diagnoseschaltung erfüllt. Dabei kann es beispielsweise aus Kostengründen vorteilhaft sein, eine separate und diskrete Ausführung zu realisieren.

Gemäß einem weiteren Ausführungsbeispiel der Erfindung ist das analoge Signal ein analoges elektrisches Stromsignal und das elektrische Stromsignal ist von einem Füllstands-, Druck- oder Durchflussmessgerät erzeugt. Weiterhin korrespondiert das elektrische Stromsignal mit einem entsprechenden Füllstands-, Druck- oder Durchflussmesswert.

Somit kann beim Einlesen eines Messwertes eines Füllstandsmessgerätes, Druckmessgeräts oder Durchflussmessgeräts zur Umwandlung in ein digitales Signal eine Überwachung der Umwandlung angegeben werden. Mit dieser Diagnoseschaltung ist es somit möglich, die analog-digitale Wandlung des analogen Stromsignals von einem Füllstands-, Druck- oder Durchflussmessgerät auf folgende Fehlfunktionen zu überprüfen: Wegdriften der ersten Stromfühlwiderstandseinheit, Wegdriften der zweiten Stromfühlwiderstandseinheit, Wegdriften der Referenzspannung des Analog-Digital-Wandlers, fehlerhafter Analog-Digital-Wandler, sowie eine fehlerhafte Programmausführung im ersten Mikrocontroller. Dabei wird die jeweilige Detektion der Fehlfunktion oder des Wegdriftens in den entsprechend oberen Absätzen der Erfindung beschrieben.

Gemäß einem weiteren Ausführungsbeispiel der Erfindung ist jeweils ein Füllstandsmessgerät, ein Druckmessgerät und ein Durchflussmessgerät mit einer Diagnoseschaltung gemäß einem der vorherigen Ausführungsbeispiele angegeben.

Gemäß einem weiteren Ausführungsbeispiel der Erfindung ist ein Verfahren zur Überwachung einer Analog-Digital-Wandlungsschaltung beim Einlesen eines Messwertes eines Füllstands-, Druck- oder Durchflussmessgerätes angegeben. Dabei weist das Verfahren die folgenden Schritte auf: Bereitstellen eines Multiplexers zum Auswählen verschiedener Signale, Bereitstellen eines ersten Mikrocontrollers zum Steuern zumindest des Multiplexers, Versorgen des Mikrocontrollers mit einer Versorgungsspannung, Messen der Versorgungsspannung, Vergleichen der gemessenen Versorgungsspannung mit einem gespeicherten Versorgungsspannungs-Referenzwertes der Versorgungsspannung und Detektieren einer Änderung der Versorgungsspannung auf Basis des Vergleichs.

Gemäß einem weiteren Ausführungsbeispiel der Erfindung ist ein Programmelement angegeben, das, wenn es auf einem Prozessor ausgeführt wird, den Prozessor anleitet, die oben angegebenen Schritte des Verfahrens durchzuführen.

Gemäß einem weiteren Ausführungsbeispiel der Erfindung ist ein computerlesbares Medium angegeben, auf dem ein Programmelement gespeichert ist, das, wenn es auf einem Prozessor ausgeführt wird, den Prozessor anleitet, die oben angegebenen Schritte des Verfahrens durchzuführen.

Dabei kann das Computerprogrammelement zum Beispiel Teil einer Software sein, die auf einem Prozessor einer Auswerteinrichtung gespeichert ist. Ebenso kann das Computerprogrammelement in einer Steuereinheit oder Computereinheit verwendet werden, welche den Sensor steuert oder regelt. Weiterhin umfasst dieses Ausführungsbeispiel der Erfindung ein Computerprogrammelement, welches von Anfang an die Erfindung verwendet, sowie auch ein Programmelement, welches durch eine Aktualisierung (Update) ein bestehendes Programm zur Verwendung der Erfindung veranlasst.

Ergänzend sei darauf hingewiesen, dass "umfassend" und "aufweisend" keine anderen Elemente oder Schritte ausschließen und "eine" oder "ein" keine Vielzahl ausschließen. Ferner sei darauf hingewiesen, dass Merkmale oder Schritte, die mit dem Verweis auf eines der obigen Ausführungsbeispiele beschrieben worden sind, auch in Kombination mit anderen Merkmalen oder Schritten anderer oben beschriebener Ausführungsbeispiele der Erfindung verwendet werden können. Bezugszeichen in den Ansprüchen sind nicht als Einschränkung anzusehen. Im Folgenden werden mit Verweis auf die Figuren Ausführungsbeispiele der Erfindung beschrieben.

Es kann als ein Kernaspekt der Erfindung angesehen werden, dass die Diagnoseschaltung einen ersten Mikrocontroller in einem ersten Bereich und einen zweiten Mikrocontroller in einem zweiten Bereich mit höheren Sicherheitsanforderungen bereitstellt. Dabei können in dem zweiten Mikrocontroller sämtliche Referenzwerte und zyklischen Abläufe und Programmabläufe, die zur Überwachung der Analog-Digital-Wandlungsschaltung beim Einlesen eines Messwertes nötig sein sollten gespeichert sein. Dies können z.B. ein Versorgungsspannungs-Referenzwert, ein Widerstands-Referenzwert; einen Programmablauf, der auf dem ersten Mikrokontroller zur Ausführung gespeichert ist, und einen Programmablauf, der durch ein Potentiometer ausgeführt wird sowie Referenzwerte für Spannungen, die von einem Potentiometer vorgegeben werden. Weiterer Teil dieses Kernaspekt kann ein unidirektionaler Koppler sein, mit dem die beiden Bereiche verbunden werden. Mit anderen Worten kann damit durch den zweiten Mikrokontroller eine Veränderung von elektrischen Widerständen, die zur Bestimmung des Messwertes verwendet werden können erkannt werden. Aber auch eine falsche Versorgungsspannung, ein Fehlerhafter Analog-Digital-Wandler und fehlerhafte Programmabläufe sind damit detektierbar. Um Fehler detektieren zu können wird eine Multiplexer im ersten Bereich angeordnet, der die entsprechenden Kanäle anschaltet. Ebenso ist ein Analog-Digitalwandler im ersten Bereich angeordnet. Auf Grund der Speicherung der Referenzwerte und Programmabläufe in dem sicheren Bereich, kann die Überwachung, die auf diesen Referenzwerten und Programmabläufen basiert als Überwachung angesehen werden, die erhöhten Sicherheitserfordernissen genügt.

### KURZE BESCHREIBUNG DER FIGUREN:

Fig. 1 zeigt eine schematische, zweidimensionale Darstellung einer Diagnoseschaltung zur Überwachung einer Analog-Digital-Schaltung beim Einlesen eines Messwertes eines Füllstands-, Druck- oder Durchflussmessgeräts gemäß einem Ausführungsbeispiel der Erfindung.
Fig. 2 zeigt eine schematische, zweidimensionale Darstellung einer Diagnoseschaltung zur Überwachung einer Analog-Digital-Wandlungsschaltung beim Einlesen eines Messwertes eines Füllstands-, Druck- oder Durchflussmessgerätes gemäß einem Beispiel der Erfindung.
Fig. 3 zeigt ein Flussdiagramm von Verfahrensschritten gemäß einem Ausführungsbeispiel der Erfindung.

In den folgenden Figurenbeschreibungen werden für die gleichen oder ähnlichen Elemente die gleichen Bezugsziffern verwendet.

Die Darstellungen in den Figuren sind schematisch und nicht maßstäblich.

### DETAILLIERTE BESCHREIBUNG VON AUSFÜHRUNGSBEISPIELEN:

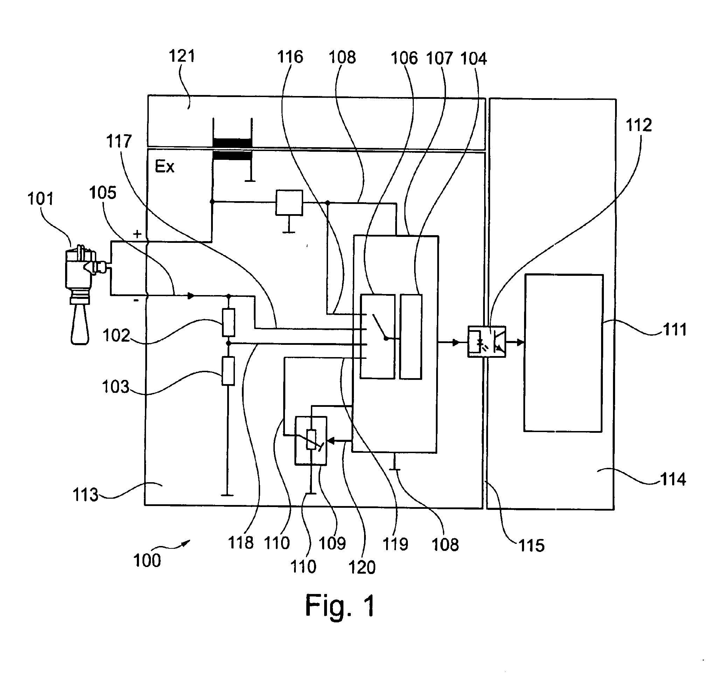

Fig. 1 zeigt eine Diagnoseschaltung zur Überwachung einer Analog-Digital-Wandlungsschaltung beim Einlesen eines Messwertes 105 eines Füllstands-, Druck- oder Durchflussmessgeräts 101. Dabei weist die Diagnoseschaltung einen Multiplexer 106 zum Auswählen verschiedener Signale, einen ersten Mikrocontroller 107 zum Steuern zumindest des Multiplexers 106 und einen Analog-Digital-Wandler 104 zum Wandeln eines analogen Signals in ein digitales Signal auf. Weiterhin weist die Diagnoseschaltung eine erste Stromfühlwiderstandseinheit 102 auf, wobei dem Mikrocontroller eine Versorgungsspannung 108 bereitgestellt wird. Dabei ist die Versorgungsspannung mittels der beiden Bezugszeichen 108 dargestellt. Diese beiden Bezugszeichen stellen jeweils ein Potentialniveau einer Spannung dar, wobei sich die Versorgungsspannung daraus als Differenz der beiden angezeigten Spannungsniveaus ergibt. Weiterhin sind eine erste Stromfühlwiderstandseinheit 102 und eine zweite Stromfühlwiderstandseinheit 103 gezeigt, die beide als elektrischer Widerstand ausgeführt geführt sein können. Weiterhin ist die Diagnoseschaltung 100 zur Detektion einer Änderung der Versorgungsspannung 108 auf Basis eines Vergleichs der Versorgungsspannung mit einem gespeicherten Versorgungsspannungs-Referenzwertes der Versorgungsspannung ausgeführt.

Weiterhin ist ein Potentiometer 109 zur Erzeugung eines analogen Potentiometersignals 110 gezeigt. Ist das analoge Potentiometersignal wiederum als eine Spannung dargestellt, die mittels der beiden Bezugszeichen 110 zwei Potentialniveaus gemäß des für das Bezugszeichen 108 erklärte Prinzips der Darstellung Spannungen dargestellt ist. Dabei kann die Versorgungsspannung 108 für den ersten Mikrocontroller 107 zur Steuerung und Regelung des Multiplexers 106 und des Analog-Digital-Wandlers 104 genutzt werden. Weiterhin ist zu sehen, dass der Multiplexer 106 hier in einer beispielhaften Ausführung mit vier Eingangskanälen 116 bis 119 ausgestattet ist, an dem jeweils ein unterschiedliches analoges Signal anliegen kann. Die Schaltung des Multiplexers kann an 116 die Versorgungsspannung abgreifen, an 117 die Spannung, die an den beiden Stromfühlwiderstandseinheiten 102 und 103 abfällt, an 118 kann die Spannung abgegriffen werden, die an Stromfühlwiderstandseinheit 103 abfällt und am Kanal 119 kann vom Multiplexer die Spannung abgegriffen werden, die von dem Potentiometer 109 erzeugt wird.

Weiterhin ist zu sehen, dass der Multiplexer 106 diese verschiedenen Kanäle auf einem Eingangskanal des Analog-Digital-Wandlers 104 gibt. Mittels eines unidirektionalen Kopplers 112 können die vom Wandler 104 digitalisierten Werte eines Messwertes 105 in den zweiten Bereich 114, wo ein zweiter Mikrocontroller 111 sitzen kann, gegeben werden. Dabei ist ein erster Bereich 113, in dem der Analog-Digital-Wandler, der Multiplexer und der erste Mikrocontroller sowie die Stromfühlwiderstandseinheiten und das Potentiometer angeordnet sind, die Richtlinien der EX Norm erfüllen. Dabei kann der zweite Bereich 114 weiterhin wie gezeigt durch eine galvanische Trennung von dem ersten Bereich separiert sein. Die galvanische Trennung 115 kann aber auch in einer anderen elektrisch entkoppelnden Art ausgeführt sein. Dabei kann beispielsweise der Versorgungsspannung-Referenzwert, der Widerstandsreferenzwert sowie ein erster zyklischer Ablauf und ein zweiter zyklischer Ablauf, die beide im vorangegangenen und im folgenden näher beschrieben werden, in dem zweiten Mikrocontroller 111 gespeichert sein.

Es ist deutlich zu sehen, dass der Mikrocontroller 107 aus dem Multiplexer 106 und dem Analog-Digital-Wandler 104 besteht. Diese integrale Ausführung des Mikrocontrollers und der jeweiligen Komponenten kann aber auch in einer diskreten und separaten Ausführung realisiert sein. Mit anderen Worten kann der Analog-Digital-Wandler diskret und der Multiplexer diskret sowie der Mikrocontroller separat ausgeführt sein. Weiterhin beschreibt der Pfeil 120 die Ansteuerung des Mikrocontrollers von dem Potentiometer, das beispielsweise als Digitalpotentiometer ausgeführt sein kann.

Dabei kann zu einer Überwachung des Einlesevorgangs eines Messwertes des Gerätes 101 folgende Bedingungen erfüllt sein: Das mathematische Verhältnis der beiden Widerstandswerte der Stromfühlwiderstandseinheiten 102 und 103 ist beispielsweise im ersten und im zweiten Mikrocontroller 111 gespeichert. Weiterhin ist es möglich, mit dem Potentiometer eine Spannung vorzugeben, die dem Eingangsbereich des Analog-Digital-Wandlers entspricht. Somit ist es möglich, den gesamten Arbeitsbereich des Analog-Digital-Wandlers einer Testmessung zu unterziehen. Weiterhin können die Kalibrierwerte für den Analog-Digital-Wandler bekannt sein und ebenso an einem beliebigen Speicherort, aber auch vorzugsweise in dem zweiten Mikrocontroller 111 gespeichert sein.

Mit dieser Diagnoseschaltung und einem entsprechenden Verfahren ist es möglich, die Analog-Digital-Wandlungsschaltung zu überwachen und entsprechende Fehler zu erkennen. Für die Verbindung zwischen Sensoreingangsschaltung, die dem ersten Bereich 113 entspricht und der Auswerteschaltung, die dem zweiten Bereich 114 entspricht, wird nur eine unidirektionale Verbindung benötigt, was vor allem bei einer eigensicheren Ausführung des Sensoreingangs von Vorteil ist. Die Begriffe "eigensicher" und "Eigensicherheit" beziehen sich auf die vom Auswertgerät bereitgestellten Sensorversorgungsspannung. Dabei ist gemeint das die Sensorversorgungsspannung so ausgeführt ist das kein Funke entstehen kann der zu einer Explosion führt. Dabei kann der erste Mikrocontroller als sogenannter grauer Kanal betrachtet werden. Das heißt, dass Fehler in einer Programmausführung des programmierbaren ersten Mikrocontrollers durch den zweiten Mikrocontroller 111 aufgedeckt werden können. Dies hat zum Vorteil, dass nur für die Programmierung des zweiten Mikrocontrollers 111 die entsprechenden Sicherheitsstandards eingehalten werden müssen. Dies bedeutet einen erheblichen Sicherheitsgewinn für das Einlesen des Messwertes durch die Diagnoseschaltung.

Mit dieser Schaltung und einem entsprechenden Verfahren ist es somit möglich, die folgenden Fehler in der Analog-Digital-Wandlerschaltung aufzudecken. Ein Wegdriften der Stromfühlwiderstandseinheiten 102 und 103, was beispielsweise durch Temperaturdrifts oder Altersprozesse bedingt sein kann. Weiterhin ist ein Wegdriften der Referenzspannung 108 des Analog-Digital-Wandlers detektierbar. Ebenso ist es möglich, eine Fehlfunktion des Analog-Digital-Wandlers selbst durch den zweiten Mikrocontroller 111 zu detektieren. Dies geschieht, wie im Weiteren näher erläutert wird, mittels des Potentiometers 109. Ebenso kann eine fehlerhafte Programmausführung im ersten Mikrocontroller 107 durch den zweiten Mikrocontroller 111 festgestellt werden.

Im Weiteren soll detaillierter auf die Detektion der Fehlfunktionen oder Drifts der verschiedenen Komponenten Diagnoseschaltung eingegangen werden. Beispielsweise kann der erste Mikrocontroller 107 derart programmiert sein, dass vom ersten Mikrocontroller zyklisch folgende Analog-Digital-Wandlerwerte an den zweiten Mikrocontroller 111 über die unidirektionale Kopplungseinheit übertragen werden: 1. Die Versorgungsspannung des ersten Mikrocontrollers, der Spannungsabfall über die Stromfühlwiderstandseinheiten 102 und 103 sowie der einzelne Spannungsabfall über der Stromfühlwiderstandseinheit 103 sowie das digitale Potentiometersignal. Der zweite Mikrocontroller empfängt diese Werte und vergleicht sie mit seinen Erwartungswerten, die genauer bezeichnet die folgenden Referenzwerte sind: 1. Der Versorgungsspannung-Referenzwert der Versorgungsspannung, 2. der Widerstandsreferenzwert der Stromfühlwiderstandseinheiten, der Referenzwert, der mittels dem Potentiometer vorgegeben wird.

Im Falle der Versorgungsspannung des ersten Mikrocontrollers wird einmalig beim Kalibrieren im Werk ein Referenzwert beispielsweise im zweiten Mikrocontroller 111 hinterlegt und gespeichert. Wenn die durch die Diagnoseschaltung 100 gemessene Versorgungsspannung 108 des ersten Mikrocontrollers 107 nicht mehr dem hinterlegten Versorgungsspannung-Referenzwert entspricht, so kann durch die Diagnoseschaltung detektiert werden, dass entweder der Analog-Digital-Wandler oder die Referenzdiode des Analog-Digital-Wandlers defekt ist.

Weiterhin kann aus dem Spannungsabfall über den Stromfühlwiderstandseinheiten 102 und 103 der Sensorstrom bestimmt werden. Dabei entspricht der Sensorstrom dem Messwert 105, der hier von dem Sensor 101 erzeugt wird. Dabei handelt es sich in dem hier gezeigten Beispiel um ein Füllstandsradarmessgerät 101. Da dem zweiten Mikrocontroller der Widerstandsreferenzwert, zum Beispiel das Verhältnis der beiden elektrischen Widerstände 102 und 103, bekannt ist, kann durch einen Vergleich das Verhältnis des Analog-Digital-Wandlerwertes für den Spannungsabfall über den Stromfühlwiderstandseinheiten 102 und 103 und dem Spannungsabfall über der Stromfühlwiderstandseinheit 103 mit dem gespeicherten Wert für das Verhältnis zwischen der Summe aus den elektrischen Widerständen 102 und 103 zu dem Wert des elektrischen Widerstandes 103 ein Wegdriften eines der beiden Widerstandswerte erkannt werden. Dabei ist in diesem vorangegangenen Abschnitt der Begriff Stromfühlwiderstandseinheit mit einem elektrischen Widerstand gleichgesetzt.

Weiterhin ist es möglich, in dem zweiten Mikrocontroller 101 einen zweiten zyklischen Ablauf zu speichern, mit welchem zweiten zyklischen Ablauf der erste Mikrocontroller jeweils ein Referenzwert mittels des Potentiometers an den Eingang des Analog-Digital-Wandlers anlegt, der dann gemessen wird und an den zweiten Mikrocontroller übertragen wird. Der zweite Mikrocontroller vergleicht diesen Wert mit dem Wert, den er erwartet. Stimmen die Werte nicht überein, deutet dies auf einen fehlerhaften Analog-Digital-Wandler oder eine fehlerhafte Referenzdiode hin.

Ebenso kann die Programmausführung des ersten Mikrocontrollers ebenso vom zweiten Mikrocontroller kontrolliert werden. Stimmt die zeitliche Abfolge der Werte von dem ersten Mikrocontroller nicht mit der vom zweiten Mikrocontroller erwarteten zeitlichen Abfolge überein, so deutet dies auf einen Programmausführungsfehler im ersten Mikrocontroller hin. Eventuell kann aber auch ein Übertragungsfehler zwischen dem ersten Mikrocontroller und dem zweiten Mikrocontroller vorliegen, was ebenso durch die Diagnoseschaltung detektiert wird.

Es ist weiterhin möglich, dass in dem zweiten Bereich 114 der Fig. 1 beispielsweise der SIL-Norm 3 oder 4 entsprechen kann, weitere Speicherbausteine, eine Anzeige, eine Tastatur und verschiedene Schnittstellen angebracht sind.

Für den eigensicheren Stromkreis gelten andere Anforderungen bzgl. der Hardware. Bei SIL wird das gesamte Gerät, Elektronik, Mechanik, Software betrachtet. Man unterscheidet nur zwischen sicherheitskritischen und nichtsicherheitskritischen Bereichen und entsprechende Einstufuingen (z.B. SIL1 oder 2).

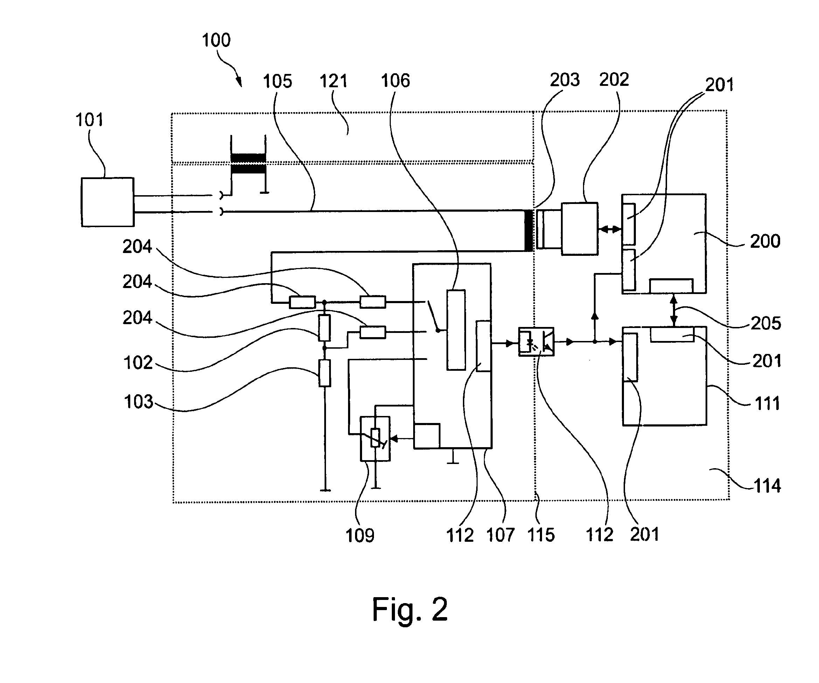

Fig. 2 zeigt ein Beispiel, in der eine Diagnoseschaltung mit weiteren elektrischen Widerständen 204 ausgestattet ist. Ebenso ist ein dritter Mikrocontroller 200 gezeigt, der in Verbindung 205 mit dem zweiten Mikrocontroller 111 steht. Ebenso ist der zweite und der dritte Mikrocontroller mit drei bzw. zwei UART-Eingängen ausgestattet. Weiterhin ist gezeigt, dass mittels einer HART Schnittstelle 202 und einer Überkragungsstelle 203 ein HART-Signal mit dem digital Werte vom Sensor 101 über die Schnittstelle 203 in den zweiten Bereich 114 übertragen werden kann. Zusätzlich wird der Strom 105 mittels des unidirektionalen Kopplers 112, der beispielsweise als elektrisch isolierender Optokoppler ausgeführt sein kann übertragen. Weiterhin ist eine galvanische Trennung 115 zu sehen, die die beiden Bereiche 113 und 114 trennt. Ebenso ist ein Netzteil 121 gezeigt. Dabei können alle genannten Referenzwerte und Programmabläufe sowie zyklischen Abläufe auch in dem dritten Mikrocontroller gespeichert sein. Aber auch eine Aufteilung auf den zweiten und dritten Mikrocontroller dieser Werte ist möglich. Die HART-Schnittstelle dient zum Übertragen von digitalen Daten an den Sensor z:B. von Parametrierdaten oder auch von digitalen Messwerten. Ein UART dient zum Senden und Empfangen von seriellen Daten (z.B. RS232 Schnittstelle).

Dabei ist es mit der Diagnoseschaltung gemäss Fig. 2 ebenso möglich, das Wegdriften der ersten und zweiten Siromfuhlwiderstandseinheit 102 und 103, die als elektrische Widerstände ausgefam sein können, zu detektieren. Aber auch ein Wegdriften der Referenzspannung 108 des Analog-Digital-Wandlers ist mit der Schaltung in oben angegebener Weise möglich. Weiterhin kann ein fehlerhafter Analog-Digital-Wandler mittels der oben beschriebenen Anwendung mit Hilfe des Potentiometers detektiert werden. Weiterhin ist eine fehlerhafte Programmausführung des ersten Mikrocontrollers durch die Diagnoseschaltung detektierbar. Zur detaillierten Beschreibung der Detektion der einzelnen Fehlfunktionen oder Drifts wird auf detaillierte Erläuterung im allgemeinen Beschreibungsteil sowie im Beschreibungsteil der Fig. 1 verwiesen.

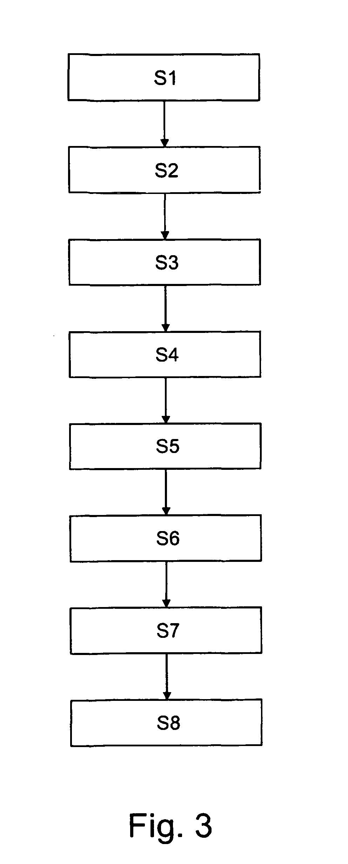

Fig.3 zeigt ein Ablaufdiagramm eines Verfahrens gemäß einem Ausführungsbeispiel der Erfindung. Dabei sind die folgenden Schritte dargestellt: Bereitstellen eines Multiplexers S3 zum Auswählen verschiedener Signale; Bereitstellen eines ersten Mikrokontrollers S4 zum Steuern zumindest des Multiplexers; Bereitstellen eines Analog-Digital-Wandlers S2 zum Wandeln zumindest eines analogen Signals in ein digitales Signal; Bereitstellen einer ersten Strohmfühlwiderstandseinheit S1; Versorgen des Mikrokontrollers mit einer Versorgungsspannung S5; Messen der Versorgungsspannung S6; Vergleichen der gemessenen Versorgungsspannung mit einem gespeicherten Versorgungsspannung-Referenzwertes der Versorgungsspannung S7; und Detektieren einer Änderung der Versorgungsspannung auf Basis des Vergleichs S8.

## Patentansprüche

1. Diagnoseschaltung (100) zur Überwachung einer Analog-Digital-Wandlungsschaltung zum Wandeln eines Messwertes (105) eines Füllstands-,
Druck- oder Durchflussmmgeffites (101) in ein digitales Signal, wobei die Diagnoseschaltung (100) aufweist:
einen Multiplexer (106) mit mindestens zwei Eingangskanälen (116, 117, 118, 119), wobei zumindest an einem Eingangskanal der Messwert (105) anliegt und zumindest ein erstes analoges Eingangssignal an einem weiteren Eingangskanal anliegt,
einen Analog-Digital-Wandler (104), der an den Ausgang des Multiplexers (106) gekoppelt ist zur Wandlung des über den Multiplexer (106) ausgewählten Eingangssignales in ein digitales Signal,
einen ersten Mikrokontroller (107) zum Steuern des Multiplexers (106),
**dadurch gekennzeichnet, dass**:
die Diagnoseschaltung (100) ferner aufweist:
einen zweiten Mikrokontroller (111), der ausgeführt ist das digital gewandelte Signal des ersten analogen Signales mit einem gespeicherten Referenzwert zu vergleichen, um so zumindest eine Fehlfunktion der Analog-Digital-Wandlungeschaltung zu detektieren,
einen ersten Bereich (113) und einen zweiten Bereich (114), die durch eine galvanische Trennung (115) separiert sind, wobei der zweite Bereich (114) ausgelegt ist, höhere Sicherheitsanforderungen gemäß einen SIL-Standard als der erste Bereich (! 13) zu erfüllen, und
einen unidirektionaler Koppler (112), zur unidirektionalen Signalübertragung von dem ersten Bereich (113) in den zweiten Bereich (114);
wobei der Multiplexer (106), der Analog-Digital-Wandler (104) und der erste Mikrokontroller (107) im ersten Bereich (113) der Diagnoseschaltung angeordnet sind,
wobei der zweite Mikrokontroller (111) im zweiten Bereich (114) der Diagnoseschaltung angeordnet ist und der Referenzwert im zweiten Bereich (114) gespeichert ist.

2. Diagnoseschaltung gemäß Anspruch 1, Weiterhin aufweisend:
eine erste Stromfühlwiderstandseinhcit (102), die zwischen den ersten Fingangskanal (117) und einem zweiten Eingangskanal (118) gekoppelt ist;
eine zweite Stromfühlwiderstandseinheit (103), die zwischen dem zweiten Eingangskanal (18) und einem Potentialniveau gekoppelt ist, wobei jeweils an beiden der Stromfühlwiderstandseinheiten (102,103) Spannungen abfallen, wobei der Multiplexer schaltbar ist jeweils eine der beiden abfallenden Spannungen auszuwählen; und
wobei die Diagnoseschaltung ausgeführt ist, die gewandelten digitalen Spannungsabfallwerte in ein Widerstandsverhältnis umzurechnen und mit einem gespeicherten digitalen Widerstandsverhältnis-Referenzwert zu vergleichen, um so eine Änderung einer der beiden Stromfühlwiderstandseinheiten (102, 103) zu detektieren.

3. Diagnoseschaltung gemäß Anspruch 2,
wobei die Diagnoseschaltung zu einer Anpassung des gespeicherten Widerstands-Referenzwerts für die Stromfühlwiderstandseinheiten ausgeführt ist, wenn die Diagnoseschaltung die Änderung detektiert, wobei die detektierte Änderung auf den gespeicherten Widerstands-Referenzwert angewendet wird.

4. Diagnoseschaltung gemäß einem der vorherigen Ansprüche, weiterhin aufweisend:
ein Potentiometer (109) zur Erzeugung eines analogen Potentiometersignals (110),
wobei das analoge Potentiometersignal (110) an einen dritten Eingangskanal (119) gekoppelt ist;
wobei die Diagnoseschaltung ausgeführt ist, das gewandelte digitale Potentiometerstignal mit einem gespeicherten, digitalen Potentiometer-Referenz-Signal zu vergleichen, um so eine Fehlfunktion des Analog-Digital-Wandlers zu detektieren.

5. Diagnosesohaltung gemäß einem der vorangehenden Ansprüche,
wobei der Multiplexer, durch den ersten Mikrokontroller (107) gesteuert, die verschiedenen Eingangskanäle (116,11'1,118,119) in einer zyklischen Abfolge auswählt, wobei die zyklische Abfolge durch eine Programmausführung des ersten Mikrokontrollers (107) bestimmt ist und der zweite Mikrokontroller (111) die gewandelten digitalen Signale in dieser Abfolge empfängt;
wobei der zweite Mikrokontroller (111) ausgeführt ist, die empfangene Abfolge mit einer zyklischen Abfolge von gespeicherten Referenzwerten zu vergleichen, um so einen Fehler in der Programmausführung zu detektieren.

6. Diagnoseschaltung gemäß Anspruch 2,
wobei die erste Stromfühlwiderstandseinheit in dem ersten Bereich (113) der Schaltung angeordnet ist.

7. Diagnoseschaltung gemäß Anspruch 1,
wobei der erste Bereich Anforderungen eines eigensicheren Stromkreises gemäß ATEX-Produktrichtlinie 94/9/EG aufweist.

8. Diagnoseschaltung gemäß einem der vorherigen Ansprüche 4 bis 7,
wobei zumindest ein Element ausgewählt aus der Gruppe bestehend aus erste Mikrokontroller, Multiplexer, Analog-Digital-Wandler, Potentiometer, erster Stromfühlwiderstandseinheit und zweiter Stromfühlwiderstandseinheit als diskretes, separates Bauteil ausgeführt ist.

9. Diagnoseschaltung gemäß einem der vorherigen Ansprüche 4 bis 8,
wobei der Messwert (105) als analoges elektrisches Stromsignal anlegbar ist; und wobei das analoge elektrische Stromsignal von einem Füllstands-, Druck- oder Durchflussmessgerät (101) erzeugt ist und mit einem entsprechenden Füllstands-, Druck- oder Durchflussmesswert korrespondiert.

10. Füllstandsmessgerät (101) mit einer Diagnoseschaltung gemäß einem der Ansprüche 1 bis 9.

11. Druckmessgerät (101) mit einer Diagnoseschaltung gemäß einem der Ansprüche 1 bis 9.

12. Durchflussmessgerät (101) mit einer Diagnoseschaltung gemäß einem der Ansprüche 1 bis 9.

13. Diagnoseschaltung gemäß Anspruch 1, wobei das analoge Eingangssignal eine Versorgungsspannung (108) des Mikrokontrollers (107) ist.

14. Verfahren in einer Diagnoseschaltung zur Überwachung einer Analog-Digital-Wandlungsschaltung zum Wandeln eines Messwertes (105) eines Füllstands-, Druck- oder Durchflussmessgerätes in ein digitales Signal, das Verfahren aufweisend die folgenden Schritte:
Bereitstellen eines Multiplexers (106) mit mindestens zwei Eingangskanälen (116, 117, 118, 119), wobei zumindest an einem Eingangskanal der Messwert (105) anliegt und zumindest ein erstes analoges Eingangssignal an einem weiteren
Eingangskanal anliegt;
In einem ersten Bereich (113) der Diagnoseschaltung (100), bereitstellen eines ersten Mikrokontrollers (107) zum Steuern zumindest des Multiplexers (106);
In einem zweiten Bereich (114) der Diagnoseschaltung (100), bereitstellen eines zweiten Mikrokontrollers (111),
In dem zweiten Bereich (114), speichern eines digitalen Referenzwertes;
Schalten des Multiplexers (106) zum Auswählen eines der Eingangskanäle;
Wandeln des über den Multiplexer (106) ausgewählten Eingangssignals in ein digitales Signal mit einem Analog-Digital-Wandler (104), der an den Ausgang des Multiplexers (106) gekoppelt ist,;
Vergleichen des digital gewandelten Signals des ersten anlogen Signals mit dem gespeicherten Referenzwert durch den zweiten Mikrokontroller (111), um so zumindest eine Fehlfunktion der Analog-Digital-Wandlungsschaltung zu detektieren;
wobei der erste Bereich (113) und der zweite Bereich (114) durch eine galvanische Trennung (115) separiert sind,
wobei der erste Bereich (113) und der zweite Bereich (114) über einen unidirektionalen Koppler (112) gekoppelt sind, zur unidirrktionalen Signalübertragung von dem ersten Bereich (113) in den zweiten Bereich (114);
wobei der zweite Bereich (114) ausgelegt ist, höhere Sicherheitsanforderungen gemäß einem SIL- Standard zu erfüllen als der erste Bereich (113),
wobei der Multiplexer (106) und der Analog-Digital-Wandler (104) in dem ersten Bereich (113) der Schaltung angeordnet sind.

## Claims

1. A diagnostic circuit (100) for monitoring an analog-to-digital conversion circuit for converting a measured value (105) of a fill level measuring device, pressure measuring device or flow measuring device (101) to a digital signal, wherein the diagnostic circuit (100) comprises:
a multiplexer (106) with at least two input channels (116, 117, 118, 119), wherein at least on one input channel the measuring value is present and at least one first analog input signal is present at a further input channel,
an analog-to-digital converter (104) that is coupled to the output of the multiplexer (106) for converting the input signal selected by way of the multiplexer (106) to a digital signal,
a first microcontroller (107) for controlling the multiplexer (106),
**characterised in that**
the diagnostic circuit (100) further comprises:
a second microcontroller (111) that is designed to compare the digitally converted signal of the first analog signal with a stored reference value in order to in this manner detect at least a malfunction of the analog-to-digital conversion circuit,
a first region (113) and a second region (114) that are set apart by galvanic separation (115), wherein
the second region (114) is designed to meet more stringent safety requirements according to an SIL standard than the first region (113), and
a unidirectional coupler (112) for unidirectional signal transmission from the first region (113) to the second region (114);
wherein the multiplexer (106), the analog-to-digital converter (104) and the first microcontroller (107) are arranged in the first region (113) of the diagnostic circuit,
wherein the second microcontroller (111) is arranged in the second region (114) of the diagnostic circuit, and the reference value is stored in the second region (114).

2. The diagnostic circuit according to claim 1, further comprising:
a first current-sensing resistor unit (102) that is coupled between the first input channel (117) and a second input channel (118);
a second current-sensing resistor unit (103) that is coupled between the second input channel (18) and a potential level, wherein in each case on both of the current-sensing resistor units (102, 103) voltages drop, wherein the multiplexer is in each case switchable so as to select one of the two dropping voltages; and
wherein the diagnostic circuit is designed to arithmetically translate the converted digital voltage drop values to a resistance ratio, and to compare them with a stored digital resistance ratio reference value in order to in this manner detect a change in one of the two current-sensing resistor units (102, 103).

3. The diagnostic circuit according to claim 2, wherein the diagnostic circuit is designed to adjust the stored resistance reference value relating to the current-sensing resistor units when the diagnostic circuit detects the change, wherein the detected change is applied to the stored resistance reference value.

4. The diagnostic circuit according to any one of the preceding claims, further comprising:
a potentiometer (109) for generating an analog potentiometer signal (110),
wherein the analog potentiometer signal (110) is coupled to a third input channel (119);
wherein the diagnostic circuit is designed to compare the converted digital potentiometer signal with a stored digital potentiometer reference signal in order to in this manner detect any malfunction of the analog-to-digital converter.

5. The diagnostic circuit according to any one of the preceding claims, wherein the multiplexer, controlled by the first microcontroller (107), selects the different input channels (116, 117, 118, 119) in a cyclical sequence,
wherein the cyclical sequence is determined by a program execution of the first microcontroller (107), and the second microcontroller (111) receives the converted digital signals in this sequence;
wherein the second microcontroller (111) is designed to compare the received sequence with a cyclical
sequence of stored reference values in order to in this manner detect an error in the program execution.

6. The diagnostic circuit according to claim 2,
wherein the first current-sensing resistor unit is arranged in the first region (113) of the circuit.

7. The diagnostic circuit according to claim 1,
wherein the first region meets the requirements of an inherently safe electrical circuit according to the ATEX product directive 94/9/EC.

8. The diagnostic circuit according to any one of the preceding claims 4 to 7,
wherein at least one element selected from the group comprising first microcontroller, multiplexer, analog-to-digital converter, potentiometer, first current-sensing resistor unit and second current-sensing resistor unit is designed as a separate component.

9. The diagnostic circuit according to any one of the preceding claims 4 to 8,
wherein the measured value (105) can be applied as an analog electrical current signal; and
wherein the analog electrical current signal is generated by a fill level measuring device, pressure measuring device or flow measuring device (101) and agrees with a corresponding fill level value, pressure value or flow measuring value.

10. A fill level measuring device (101) with a diagnostic circuit according to any one of claims 1 to 9.

11. A pressure measuring device (101) with a diagnostic circuit according to any one of claims 1 to 9.

12. A flow measuring device (101) with a diagnostic circuit according to any one of claims 1 to 9.

13. The diagnostic circuit according to claim 1,
wherein the analog input signal is a supply voltage (108) of the microcontroller (107).

14. A method in a diagnostic circuit for monitoring an analog-to-digital conversion circuit for converting a measured value (105) of a fill level measuring device, pressure measuring device or flow measuring device to a digital signal, with the method comprising the following steps:
providing a multiplexer (106) with at least two input channels (116, 117, 118, 119), wherein at least at one input channel the measuring value (105) is present,
and at least one first analog input signal is present at a further input channel;
in a first region (113) of the diagnostic circuit (100), providing a first microcontroller (107) for controlling at least the multiplexer (106);
in a second region (114) of the diagnostic circuit (100) providing a second microcontroller (111),
in the second region (114) storing a digital reference value;
switching the multiplexer (106) for selecting one of the input channels;
converting the input signal selected by way of the multiplexer (106) to a digital signal with an analog-to-digital converter (104) that is coupled to the output of the multiplexer (106),;
comparing, by means of the second microcontroller (111), the digitally converted signal of the first analog signal with the stored reference value in order
to in this manner detect at least a malfunction of the analog-to-digital conversion circuit,
wherein the first region (113) and the second region (114) are set apart by galvanic separation (115),
wherein the first region (113) and the second region (114) are coupled by way of a unidirectional coupler (112), for unidirectional signal transmission from the first region (113) to the second region (114);
wherein the second region (114) is designed to meet more stringent safety requirements according to an SIL standard than the first region (113),
wherein the multiplexer (106) and the analog-to-digital converter (104) are arranged in the first region (113) of the diagnostic circuit.

## Revendications

1. Circuit de diagnostic (100) pour le contrôle d'un circuit de conversion analogique - numérique destiné à la conversion d'une valeur de mesure (105) d'un appareil de mesure de niveau, de pression ou de débit(101) en un signal numérique, le circuit de diagnostic (100) comprenant :
un multiplexeur (106) avec au moins deux voies d'entrée (116, 117, 118, 119), la valeur de mesure (105) s'appliquant au moins sur une voie d'entrée et au moins un premier signal d'entrée analogique s'appliquant sur une autre voie d'entrée,
un convertisseur analogique - numérique (104), qui est couplé à la sortie du multiplexeur (106) pour la conversion du signal d'entrée, sélectionné par l'intermédiaire du multiplexeur (106), en un signal numérique,
un premier microcontrôleur (107) pour le contrôle du multiplexeur (106),
**caractérisé en ce que** :
le circuit de diagnostic (100) comprend par ailleurs :
un second microcontrôleur (111), qui est réalisé pour comparer le signal numérique converti du premier signal analogique à une valeur de référence mémorisée, afin de détecter ainsi au moins une erreur de fonctionnement du circuit de conversion analogique - numérique,
une première zone (113) et une seconde zone (114), qui sont séparées par une séparation galvanique (115), la seconde zone (114) étant conçue pour remplir des exigences de sécurité plus élevées, selon une norme SIL, que la première zone (113), et
un coupleur unidirectionnel (112), pour la transmission unidirectionnelle de signaux de la première zone (113) à la seconde zone (114) ;
le multiplexeur (106), le convertisseur analogique - numérique (104), et le premier microcontrôleur (107) étant disposés dans la première zone (113) du circuit de diagnostic,
le second microcontrôleur (111) étant disposé dans la seconde zone (114) du circuit de diagnostic et la valeur de référence étant mémorisée dans la seconde zone (114).

2. Circuit de diagnostic selon la revendication 1, comprenant en outre :
une première unité de résistance sensible au courant (102), qui est couplée entre la première voie d'entrée (117) et une seconde voie d'entrée (118) ;
une seconde unité de résistance sensible au courant (103), qui est couplée entre la seconde voie d'entrée (118) et un niveau de potentiel, des tensions chutant respectivement aux deux bornes des unités de résistance sensibles au courant (102, 103), le multiplexeur étant connectable pour sélectionner respectivement l'une des deux chutes de tension ; et
le circuit de diagnostic étant réalisé pour convertir les valeurs de chute de tension numériques converties en un rapport de résistances et les comparer à une valeur de référence de rapport de résistances numérique mémorisé, afin de détecter ainsi une variation de l'une des deux unités de résistance sensibles au courant (102, 103).

3. Circuit de diagnostic selon la revendication 2,
le circuit de diagnostic étant réalisé pour une adaptation de la valeur de référence de résistance mémorisée pour les unités de résistance sensibles au courant, lorsque le circuit de diagnostic détecte la variation, la variation détectée étant appliquée à la valeur de référence de résistance mémorisée.

4. Circuit de diagnostic selon l'une des revendications précédentes, comprenant en outre :
un potentiomètre (109) pour générer un signal potentiométrique analogique (110),
le signal potentiométrique analogique (110) étant couplé à une troisième voie d'entrée (119) ;
le circuit de diagnostic étant réalisé pour comparer le signal potentiométrique numérique converti à un signal de référence potentiométrique numérique, mémorisé, afin de détecter ainsi une erreur de fonctionnement du convertisseur analogique - numérique.

5. Circuit de diagnostic selon l'une des revendications précédentes,
le multiplexeur, contrôlé par le premier microcontrôleur (107), sélectionnant les différentes voies d'entrée (116, 117, 118, 119) dans un ordre cyclique, l'ordre cyclique étant déterminé par une exécution de programme du premier microcontrôleur (107) et le second microcontrôleur (111) recevant dans cet ordre les signaux numériques convertis ;
le second microcontrôleur (111) étant réalisé pour comparer l'ordre reçu à un ordre cyclique de valeurs de référence mémorisées, afin de détecter ainsi une erreur dans l'exécution de programme.

6. Circuit de diagnostic selon la revendication 2,
la première unité de résistance sensible au courant étant disposée dans la première zone (113) du circuit.

7. Circuit de diagnostic selon la revendication 1,
la première zone présentant des exigences d'un circuit électrique à sécurité intrinsèque selon la directive ATEX 94/9/CE.

8. Circuit de diagnostic selon l'une des revendications précédentes 4 à 7,
au moins un élément étant sélectionné parmi le groupe constitué d'un premier microcontrôleur, multiplexeur, convertisseur analogique - numérique, potentiomètre, d'une première unité de résistance sensible au courant et d'une seconde unité de résistance sensible au courant, sous forme de composant discret, séparé.

9. Circuit de diagnostic selon l'une des revendications précédentes 4 à 8,
la valeur de mesure (105) étant applicable sous forme de signal électrique analogique ; et
le signal électrique analogique étant généré par un appareil de mesure de niveau, de pression ou de débit (101) et correspondant à une valeur de mesure appropriée de niveau, de pression ou de débit.

10. Appareil de mesure de niveau (101) avec un circuit de diagnostic selon l'une des revendications 1 à 9.

11. Appareil de mesure de pression (101) avec un circuit de diagnostic selon l'une des revendications 1 à 9.

12. Appareil de mesure de débit (101) avec un circuit de diagnostic selon l'une des revendications 1 à 9.

13. Circuit de diagnostic selon la revendication 1, le signal d'entrée analogique étant une tension d'alimentation (108) du microcontrôleur (107).

14. Procédé dans un circuit de diagnostic pour le contrôle d'un circuit de conversion analogique - numérique destiné à la conversion d'une valeur de mesure (105) d'un appareil de mesure de niveau, de pression ou de débit en un signal numérique ; le procédé comprenant les étapes suivantes :
mise en place d'un multiplexeur (106) avec au moins deux voies d'entrée (116, 117, 118, 119), la valeur de mesure (105) s'appliquant au moins sur une voie d'entrée et au moins un premier signal d'entrée analogique s'appliquant sur une autre voie d'entrée ;
dans une première zone (113) du circuit de diagnostic (100), mise en place d'un premier microcontrôleur (107) pour le contrôle d'au moins le multiplexeur (106) ;
dans une seconde zone (114) du circuit de diagnostic (100), mise en place d'un second microcontrôleur (111),
dans la seconde zone (114), mémorisation d'une valeur de référence numérique ;
connexion du multiplexeur (106) pour la sélection de l'une des voies d'entrée ;
conversion du signal d'entrée, sélectionné par l'intermédiaire du multiplexeur (106), en un signal numérique par un convertisseur analogique - numérique (104), couplé à la sortie du multiplexeur (106) ;
comparaison du signal converti numérique du premier signal analogique à la valeur de référence mémorisée par le second microcontrôleur (111), afin de détecter ainsi au moins une erreur de fonctionnement du circuit de conversion analogique - numérique ;
la première zone (113) et la seconde zone (114) étant séparées par une séparation galvanique (115) ;
la première zone (113) et la seconde zone (114) étant couplées par l'intermédiaire d'un coupleur unidirectionnel (112), pour la transmission unidirectionnelle de signaux de la première zone (113) à la seconde zone (114) ;
la seconde zone (114) étant conçue pour remplir des exigences de sécurité plus élevées, selon une norme SIL, que la première zone (113),
le multiplexeur (106) et le convertisseur analogique - numérique (104) étant disposés dans la première zone (113) du circuit.
